(19) **Europäisches Patentamt**

**European Patent Office**

**Office européen des brevets**

(11) Veröffentlichungsnummer : **0 281 188 B1**

(12) **EUROPÄISCHE PATENTSCHRIFT**

(45) Veröffentlichungstag der Patentschrift :
**14.09.94 Patentblatt 94/37**

(21) Anmeldenummer : **88200308.0**

(22) Anmeldetag : **22.02.88**

(51) Int. Cl.⁵ : **H01S 3/096,** H01S 3/133

(54) Regelung von Laserdioden.

(30) Priorität : **28.02.87 DE 3706572**

(43) Veröffentlichungstag der Anmeldung :
**07.09.88 Patentblatt 88/36**

(45) Bekanntmachung des Hinweises auf die
Patenterteilung :
**14.09.94 Patentblatt 94/37**

(84) Benannte Vertragsstaaten :
**BE DE FR GB NL**

(56) Entgegenhaltungen :
**EP-A- 0 061 034**
**US-A- 4 355 395**
**PATENT ABSTRACTS OF JAPAN, Band 9, Nr.**
**150 (E-324)[1873], 25. Juni 1985 & JP-A-60 31**
**323**

(73) Patentinhaber : **Philips Patentverwaltung**
**GmbH**
**Wendenstrasse 35c**
**D-20097 Hamburg (DE)**
㊄ **DE**
Patentinhaber : **N.V. Philips'**
**Gloeilampenfabrieken**
**Groenewoudseweg 1**
**NL-5621 BA Eindhoven (NL)**
㊄ **BE FR GB NL**

(72) Erfinder : **Bathe, Paul, Dipl.-Ing. (FH)**
**Eckenhaiderhauptstrasse 62**
**D-8501 Eckental (DE)**

(74) Vertreter : **Peuckert, Hermann, Dipl.-Ing. et al**
**Philips Patentverwaltung GmbH,**
**Wendenstrasse 35c**
**D-20097 Hamburg (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 281 188 B1

**Beschreibung**

Die Erfindung betrifft eine Schaltungsanordnung zur Regelung von Laserdioden mit einer Vorstromquelle zur Vorgabe eines Arbeitspunktes mittels eines durch die Laserdiode fließenden Vorstroms, einer Pulsstromquelle zur Modulation der Laserdiode mittels eines durch die Laserdiode fließenden Pulsstroms, einer mit der Laserdiode gekoppelten Fotodiode zur Messung der optischen Ausgangsleistung der Laserdiode und mit einer Regelschaltung zur Regelung der optischen Ausgangsleistung der Laserdiode. Die Erfindung betrifft auch ein Verfahren zur Regeluung einer Laserdiode. Bevorzugte Anwendung der Erfindung sind optische Übertragungssysteme.

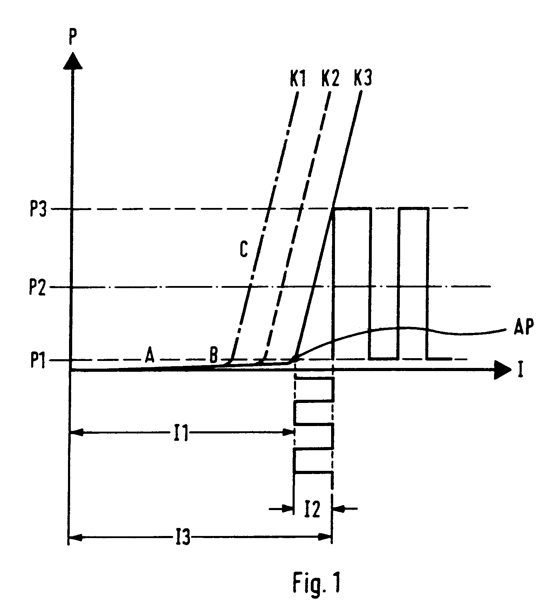

Laserdioden werden in optischen Übertragungssystemen als Lichtsender verwendet. Für die Strom-Licht-Kennlinie (Fig. 1) einer Laserdiode (im folgenden nur noch als Kennlinie bezeichnet), kann man drei Bereiche unterscheiden:

Ein Kurvenstück A mit geringer Steigung, in welchem noch keine Ausstrahlung kohärenten Lichtes stattfindet, daran anschließend das sogenannte Schwellgebiet B, welches einen Kennlinienknick enthält und schließlich ein steileres Kennlinienstück C mit konstanter Steigung, in welchem ein linearer Zusammenhang zwischen Ansteuerstrom und optischer Ausgangsleistung besteht.

Zur Verbesserung des Betriebsverhaltens ist es zweckmäßig, einen Vorstrom 11 durch die Laserdiode fließen zu lassen, wodurch ein Arbeitspunk AP auf der Kennlinie K3 festgelegt wird. Hierbei wird man den Arbeitspunkt des Vorstroms so wählen, daß er zur Vermeidung von Verzögerungseffekten im Schwellgebiet der Kennlinie oder darüber liegt. Einen zu großen Vorstrom wird man aber wegen der Verkürzung der Lebensdauer und Empfindlichkeitseinbußen des Empfängers infolge zusätzlichen Gleichlichtsrauschen ebenfalls vermeiden. Bei einem konstanten Vorstrom wird sich dieser Arbeitspunkt jedoch durch die thermische und alterungsbedingte Drift der Kennlinie verändern.

Aus der europäischen Patentanmeldung 0 061 034 ist eine Schaltungsanordnung bekannt, bei der die optische Ausgangsleistung einer Laserdiode mittels einer Fotodiode gemessen und durch digitale Schaltelemente auf vorgebbare Werte geregelt wird, indem der Vorstrom solange stufenweise erhöht wird, bis die vorgebbare optische Mindestleistung von der Laserdiode abgegeben wird. Auf diese Weise wird ein vorher festzulegender Arbeitspunkt eingestellt. Wird nun durch Zuschalten des Pulsstromes die Laserdiode moduliert und dabei die ebenfalls einstellbare Höchstleistung überschritten, so wird der Vorstrom stufenweise herabgesetzt, bis sich die mittlere optische Ausgangsleistung wieder unter diesem Maximalpegel befindet. Sollte die Ausgangsleistung unter die Mindestleistung absinken, wird der Vorstrom wiederum entsprechend erhöht.

Bedingung für eine gute Regelbarkeit ist, wie in dieser Veröffentlichung dargelegt wird, daß die durch den Pulsstrom verursachte mittlere optische Modulationsleistung geringfügig kleiner ist als die Leistungsdifferenz der eingestellten Maximal- und Minimalwerte. Die mittlere optische Ausgangsleistung läßt sich mit Hilfe des Minimal-und des Maximalpegels nur indirekt einstellen. Da eine Nachregelung aber nur bei Überschreiten des oberen bzw. Unterschreiten des unteren Pegels vorgesehen ist, wird die mittlere optische Ausgangsleistung, solange sie sich zwischen diesen beiden Pegeln bewegt, überhaupt nicht geregelt.

Da Laserdioden großen Exemplarsteuerungen unterliegen, muß die Festlegung des Arbeitspunktes für jedes einzelne Exemplar jeweils neu erfolgen. Hierzu wird aus der für jedes Exemplar anzufertigenden Kennlinie der Arbeitspunkt nach den obigen Gesichtspunkten ausgewählt, die zugehörige optische Leistung aus der Kennlinie entnommen und in der digitalen Schaltung als Parameter entsprechend vorgegeben, Die Verstärkung der Modulationsstufe ist dann noch so an die jeweilige Steilheit der Kennlinie anzupassen, daß die Anforderungen an die Modulationsleistung erfüllt werden. Nach jedem Austausch der Laserdiode ist diese aufwendige Prozedur zu wiederholen. Aber auch durch die alterungsbedingte Drift wird von Zeit zu Zeit ein solcher mit nicht geringem Aufwand verbundener Abgleich erforderlich.

Der vorliegenden Erfindung liegt die Aufgabe zugrunde, ein Verfahren anzugeben, mit dem die Bestimmung des Arbeitspunktes derLaserdiode soweit vereinfacht wird, daß ein manueller Abgleich auf einen bestimmten Arbeitspunkt nicht mehr erforderlich ist. Der Arbeitspunkt soll unabhängig von einer thermischen oder alterungsbedingten Drift der-Kennlinie nachführbar sein. Die optische Ausgangsleistung der Laserdiode soll präzise regelbar und in einfacher Weise einstellbar bzw. veränderbär sein. Ohne Änderung von Parametern soll dieses Verfahren selbst für unterschiedliche Typen von Laserdioden durchführbar sein.

Diese Aufgabe wird erfindungsgemäß bei einer Schaltungsanordnung der eingangs erwähnten Art dadurch gelöst, daß zur Leistungsregelung der Laserdiode die Regelschaltung den Vorstrom nachregelt und daß zur Bestimmung des Arbeitspunktes der Laserdiode aus dem augenblicklichen Kennlinienverlauf die Regelschaltung den Pulstrom um einen bestimmten Betrag solange ändert, bis der Quotient aus der sich auf die jeweilige Pulsstromänderung einstellenden Änderung des Vorstroms und der jeweils vorgenommen Pulsstromänderung mit einem vorgegebenen Sollwert übereinstimmt, wobei der Arbeistpunkt an einen Punkt der Kennlinie gelegt wird, an dem die Steilheit niedriger als die Steilheit im linearen Bereich der Kennlinie ist.

Ein erfindungsgemäßes Verfahren zur Regelung einer Laserdiode sieht vor, daß ein vorgebbarer Arbeitspunkt unmittelbar aus dem augenblicklichen Kennlinienverlauf bestimmt wird, wobei durch Auswertung der Kennliniensteilheiten der Arbeitspunkt mittels eines Vorstroms an einen Punkt der Kennlinie gelegt wird, an dem die Steilheit niedriger als die Steilheit im linearen Teil der Kennlinie ist, indem die optische Ausgangsleistung der Laserdiode mittels des Vorstroms geregelt wird, die Laserdiode mit einem Wechselstrom, dessen Mittelwert konstant ist, moduliert wird und die Amplitude dieses Wechselstroms so lange geändert wird, bis der Quotient aus der Differenz der beiden letzten Amplitudenwerte des Wechselstroms und der Differenz der beide Werte des Vorstroms vor und nach der auf die Amplitudenänderung des Wechselstroms erfolgenden Regelung der Ausgangsleistung einen bestimmten Wert einnimmt.

Hierdurch wird der Arbeitspunkt an den Punkt der Kennlinie gelegt, an dem die Steilheit um einen definierten Faktor gegenüber der Steilheit im linearen Teil der Kennlinie abgenommen hat.

Ein wesentlicher Vorteil der Erfindung liegt darin, daß der Aussteuerbereich der Laserdiode ohne zusätzlichen Aufwand optimiert wird. Mit der Bestimmung des Arbeitspunktes wird gleichzeitig der Wert des Modulationsstroms festgelegt. Die erfindungsgemäße Lösung bietet den Vorteil, daß ein aufwendiger manueller Vorabgleich und spätere Justierungen entfallen. Die Erfindung bietet weiterhin den Vorteil, daß weder bezüglich des Dunkelstromverhaltens noch bezüglich der Diodenkapazität besondere Anforderungen an die Monitorfotodiode gestellt werden müssen. Die Monitorfotodiode kann ohne Vorspannung betrieben werden.

Die Erfindung soll im folgenden anhand der in der Zeichnung dargestellten Ausführungsbeispiele beschrieben und erläutert werden.

Es zeigen in schematischer Darstellung:

Fig. 1 die Kennlinie einer Laserdiode bei unterschiedlichen Temperaturen und die Arbeitsweise für einen Arbeitspunkt im linearen Teil der Kennlinie.

Fig. 2 eine Anordnung zur Durchführung des Verfahrens.

Fig. 3 die Kennlinie einer Laserdiode und die Stromverläufe während eines Regelvorgangs zur Bestimmung des Arbeitspunktes.

Fig. 4 einen Ausschnitt aus einem Ausführungsbeispiel für eine Steuerschaltung.

In der Fig. 1 sind die Kennlinien einer Laserdiode für drei verschiedene Temperaturen aufgetragen (Temperatur für Kennlinie K3 größer als Temperatur für Kennlinie K2, Temperatur für Kennlinie K2 größer als Temperatur für Kennlinie K1). I1 bezeichnet den Vorstrom, der den Arbeitspunkt AP auf der Kennlinie K3 festlegt. Der Pegel P1 kennzeichnet die Ausgangsleistung, die bei diesem Arbeitspunkt ohne Modulation abgestrahlt wird. Durch Addition des Pulsstroms I2 wird die Spitzenleistung P3 abgestrahlt, die mittlere Ausgangsleistung entspricht dem Pegel P2.

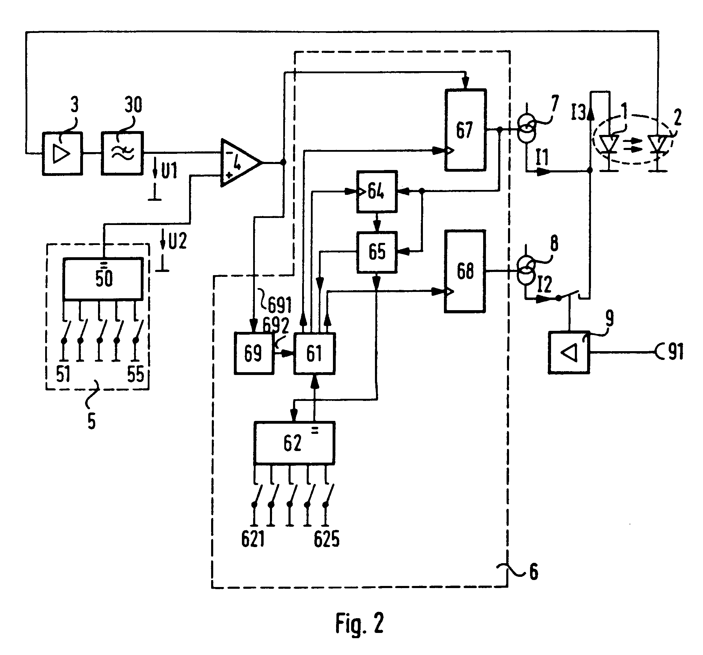

Figur 2 zeigt ein Ausführungsbeispiel, bei dem das zu übertragende Signal als binär-codiertes Signal vorliegt. Hierbei ist es vorteilhaft, die Ausgangsleistung der Laserdiode über die mittlere optische Leistung zu regeln. An eine Laserdiode 1, die als optischer Sender dient und deren Licht zum Teil in die nicht dargestellte Glasfaser abgestrahlt wird, ist eine Monitorfotodiode 2 angekoppelt, die den anderen Teil des von der Laserdiode emittierten Lichtes empfängt. Die Monitorfotodiode 2 ist mit einem Eingang eines Meßverstärkers 3 verbunden. Ein dem Meßverstärker nachgeschaltetes Tiefpaßfilter 30 wandelt den Fotostrom in eine zur mittleren Leistung proportionale Spannung U1 um, welche an den invertierenden Eingang eines analogen Komparators 4 gelegt ist.

Ein Referenzspannungsgenerator 5 bestehend aus einer Reihe von fünf Schaltern 51 - 55, mit deren Schalterstellungen ein binärer Wert vorgegeben wird, und einem D/A-Wandler 50, der diesen binären Wert in eine proportionale Referenzspannung U2 umsetzt, legt diese Referenzspannung U2 an den nicht invertierenden Eingang des analogen Komparators 4. Die optische Ausgangsleistung der Laserdiode ist zu dieser Referenzspannung U2 direkt proportional. Im Ausführungsbeispiel wird ein logarithmischer D/A-Wandler eingesetzt, was den Vorteil bietet, daß die Ausgangsleistung in dB-Stufen eingestellt wird.

Die am Ausgang des analogen Komparators 4 anstehenden binären Werte werden der Steuerlogik 6 und zwar insbesondere der darin enthaltenen Auswertelogik 69 zugeführt. Die Auswertelogik 69 tastet das Ausgangssignal des Komparators periodisch ab und speichert den abgetasteten Binärwert für wenigstens eine Periodendauer in einem nicht dargestellten Register. Einem ebenfalls nicht dargestellten XOR-Gatter wird das neueste abgetastete Ausgangssignal und das eine Periode zuvor abgetastete Ausgangssignal, welches im erwähnten Register gespeichert ist, zugeführt. Das Ausgangssignal des XOR-Gatters liegt an dem Ausgang 692 der Auswertelogik 69 an.

Die Steuerlogik 6 enthält weiterhin eine Ablaufsteuerung 61, die verschiedene periodische Taktsignale und in Abhängigkeit der ihr zugeführten Eingangssignale verschiedene Steuersignale erzeugt. Außerdem beinhaltet die Steuerlogik im wesentlichen noch eine zweite Reihe von fünf Schaltern 621 bis 625, mit welchem ein zweiter binärer Wert einem binären Vergleicherbaustein 62 vorgegeben wird, ein Register 64, einen Subtrahierer 65 und zwei Zähler 67 und 68. Die Steuerlogik 6 steuert mit den Ausgängen der Zähler 67 und 68 zwei digital steuerbare Stromquellen 7 und 8. Der Vorstrom I1 durch die Laserdiode 1 wird durch die Stromquelle 7 erzeugt. Eine Pulsstufe 9 überlagert dem Vorstrom I1 bei Vorhandensein eines Hochpegels am Dateneingang 91 einen von der Stromquelle 8 gelieferten Pulsstrom I2. Die Summe dieser zwei überlagerten Ströme I1 und I2 ist im folgenden als Modulationsspitzenstrom I3 bezeichnet.

Bei den durch Temperaturänderungen verursachten Änderungen der optischen Ausgangsleistung verschiebt sich die Kennlinie bei Temperaturerhöhung nach rechts bzw. bei Temperaturerniedrigung nach links (Fig. 1). Da sich hierdurch der Steigungsverlauf der Kennlinie nicht wesentlich ändert, kann auf eine erneute Bestimmung des Arbeitspunktes verzichtet werden. Es ist ausreichend, den Vorstrom entsprechend nachzustellen, weshalb es sich als besonders vorteilhaft erwiesen hat, die Leistungsregelung nur über den Vorstrom durchzuführen. Bei temperaturbedingter Kennliniendrift wird auf diese Weise die einmal festgelegte relative Lage des Arbeitspunktes zum Kennlinienknick stets beibehalten.

Zunächst ist daher die Arbeitsweise der Leistungsregelung für den Fall beschrieben, daß der gewünschte Arbeitspunkt bereits eingestellt und der Regelkreis eingeschwungen ist. Wenn sich nun die abgestrahlte Leistung gegenüber der geforderten Leistung verringert, verringert sich dadurch ebenfalls der Fotostrom der Fotodiode 2. Hierdurch wird die Spannung U1 kleiner als die Spannung U2, der analoge Komparator 4 liefert Hochpegel. Der Ausgang des analogen Komparators 4 ist mit dem Zählrichtungseingang des Zählers 67 verbunden. Dieser zählt bei Hochpegel vorwärts und bei Niedrigpegel rückwärts. Von der Ablaufsteuerung 61 an den Zähleingang des Zählers 67 gesandte Impulse erhöhen daher schrittweise den Zählerstand und somit den von der Stromquelle 7 abgegebenen Strom I1. Durch den zunehmenden Vorstrom I1 wird die Leistung so lange erhöht, bis sie größer als die geforderte Leistung ist; der analoge Komparator wechselt auf Niedrigpegel.

Wegen des Niedrigpegels des analogen Komparators wird die Zählrichtung des Zählers 67 gewechselt und die Impulse der Ablaufsteuerung 61 erniedrigen den Zählerstand des Zählers 67, der von der Stromquelle 7 abgegebene Strom wird vermindert. Da hierdurch die abgestrahlte Leistung nun wieder kleiner ist als die geforderte Leistung, kippt der Komparator sofort zurück. Da ein analoger Komparator nur schwer einen stabilen Gleichgewichtszustand einnehmen kann, schwankt die abgestrahlte Leistung um den mit U2 vorgegebenen Pegel. Im eingeschwungenen Zustand der Leistungsregelung liefert der analoge Komparator 4 abwechselnd Niedrig- und Hochpegel. Durch Überwachung der abgetasteten Komparatorpegel kann die Auswertelogik 69 den eingeschwungenen Zustand der Leistungsregelung feststellen und gibt in diesem Fall über den Ausgang 692 ein entsprechendes Signal an die Ablaufsteuerung 61.

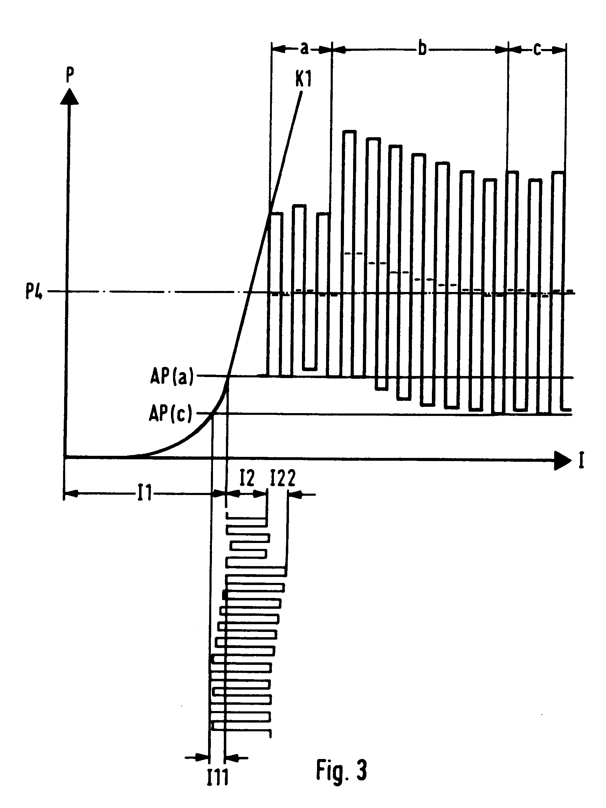

Zu Beginn eines jeden Verfahrensschrittes, mit welchem die augenblickliche Lage des eingestellten Arbeitspunktes bestimmt wird, muß zunächst der eingeschwungene Zustand der Leistungsregelung abgewartet werden (Phase a in Fig. 3: Die Ausgangsleistung, dargestellt durch die waagerechten Striche, pendelt um die vorgegebene Leistung P4). Sobald die Auswertelogik 69 den eingeschwungenen Zustand der Leistungsregelung signalisiert, ändert die Ablaufsteuerung 61 den Zählerstand des Zählers 68 um ein Bit, wodurch sich der Pulsstrom I2 um einen kleinen Betrag I22 (der besseren Darstellbarkeit wegen ist in Fig. 3 der Betrag von I22 ca. halb so groß wie der Betrag von I2 gezeichnet) ändert. Hierdurch ändert sich auch die Ausgangsleistung der Laserdiode (Beginn der Phase b in Fig. 3), wodurch die Leistungsregelstufe zu einer dem Pulsstrom gegenläufigen Änderung des Vorstromes gezwungen wird. Nach Einschwingen der Leistungsregelung (Phase c in Fig. 3) hat sich der Wert des Vorstroms I1 um den Betrag I11 (siehe Fig. 3), der die durch I22 verursachte Leistungsänderung ausgleicht, geändert.

Das Verhältnis I11 zu I22, es sei im folgenden k genannt, ist wie folgt abhängig vom Tastgrad d des Pulsstroms I2 und einem Faktor S, der dem Verhältnis aus der Kennliniensteigung am Punkt des Modulationsspitzenstroms I3 und der Kennliniensteigung am Punkt des Vorstroms I1 entspricht:

$$k = \frac{s}{s + \frac{1-d}{d}} \quad (1)$$

Der Gedanke liegt darin, den Faktor S zur eindeutigen Beschreibung eines gewünschten Arbeitspunktes heranzuziehen, während die Bestimmung dieses Arbeitspunktes mittels des jeweiligen Wertes k durchgeführt wird.

Da für den Betrieb der Laserdiode der Modulationsspitzenstrom I3 im Ausführungsbeispiel stets so gewählt ist, daß er im linearen Teil der Kennlinie liegt, besteht unterhalb des linearen Teils der Kennlinie wegen der monoton steigenden Kennlinie einer Laserdiode eine eindeutige Zuordnung zwischen Steigungsverlauf und den Werten des Faktors S. Liegt auch der Wert des Vorstroms I1 im linearen Teil der Kennlinie, so ist der Wert dieses Faktors S gleich eins, weiter unterhalb wird er zunehmend größer als eins.

Mit der Vorgabe eines bestimmten Wertes für den Faktor S kann die relative Lage des Arbeitspunktes in Bezug auf den Beginn des linearen Teils der Kennlinie festgelegt werden. Dies bietet den entscheidenden Vorteil, daß der Arbeitspunkt unabhängig von den absoluten Werten der Kennlinie, die wegen Exemplarstreuungen sehr unterschiedlich sein können, eingestellt wird. Bei Werten für den Faktor S geringfügig größer als eins liegt der Arbeitspunkt in der Nähe des Schwellgebietes, größere Werte für den Faktor S verschieben den Arbeitspunkt immer mehr in Richtung des flachen Teils A der Kennlinie.

Da der Wert für d vorgegeben ist, der Wert für S entsprechend dem gewünschten Arbeitspunkt gewählt wird, ergibt sich das für den gewählten Arbeitspunkt erforderliche Verhältnis von I22 zu I11 als Wert für den Faktor k aus obiger Beziehung (1). Der aus dem beschriebenen Verfahrensschritt ermittelte Istwert für den Faktor k wird im folgenden als k(AP) bezeichnet. Hingegen wird der zur Beschreibung des Arbeitspunktes ausgewählte und mittels der Schalter 621 ...625 vorgegebene Wert für den Faktor k im folgenden als Sollwert K bezeichnet. Zur Bestimmung des Arbeitspunktes werden in aufeinanderfolgenden Verfahrensschritten der Pulsstrom I2 und der Vorstrom I1 so lange verändert, bis der jeweils neu ermittelte Istwert k(AP) mit dem für den gewünschten Arbeitspunkt vorgegebenen Sollwert K übereinstimmt.

Nach dem Starten der Steuerlogik wird der Vorstrom I1 so lange erhöht, bis die vorgewählte Ausgangsleistung erreicht ist. Der Pulsstrom wird hierbei zunächst auf dem Wert Null gehalten. Im Ausführungsbeispiel ist die Ausgangsleistung stets so gewählt, daß sich der hierfür ergebende Arbeitspunkt stets im linearen Teil der Kennlinie befindet. Der Wert des Vorstroms I1 dieses ersten Arbeitspunktes ist der kleinste Wert, den der Modulationsspitzenstrom I3 bei der vorgegebenen Leistung einnehmen kann. Nach Zuschalten eines Pulsstroms I2 von beliebiger Größe ist somit gewährleistet, daß der Modulationsspitzenstrom I3 stets im linearen Teil der Kennlinie bleibt. Unabhängig von der Amplitude des Pulsstroms I2 wird somit stets die Steigung im linearen Teil der Kennlinie als Bezugsgröße für die Bildung des Istwerts k(AP) herangezogen. Die Steuerlogik speichert den Zählerstand des Zählers 67 für die Vorstromquelle 7 in der Registerzelle 64 und inkrementiert dann den Zähler 68, mit dem der Pulsstrom I2 um einen Schritt I22 erhöht wird. Infolge des hierdurch verursachten Leistungsanstiegs wird nun der Vorstrom so lange vermindert, bis die vorgegebene Leistung wieder erreicht ist. Mit dem Subtrahierer 65 wird die Differenz aus dem jetzigen Zählerstand des Zählers 67 für die Vorstromquelle und dem in der Registerzelle 64 gespeicherten Wert des Zählerstandes des Zählers 67 vor der Pulsstromerhöhung gebildet und mit dem Vergleicherbaustein 62 mit dem durch die Schalterstellungen der Schalter 621 bis 625 vorgegebenen Wert für den Faktor k verglichen.

In dem Ausführungsbeispiel und der dazugehörigen Fig. 3, die den Signalverlauf während der Bestimmung des Istwerts k(AP) schematisiert wiedergibt, sind die Stromquellen so dimensioniert, daß der Betrag eines Pulsstromschritts 10 Vorstromschritten entspricht. Auf diese Weise kann der Istwert k(AP) bei der Messung mit einer Nachkommastelle aufgelöst werden. In Phase b waren zur Erreichung des Arbeitspunktes AP(c) sieben Herabstufungen des Vorstroms I1 notwendig, woraus sich für den Istwert k(c) der Wert 0,7 ergibt.

Diesen Vorgang wiederholt die Steuerlogik so lange, bis der Istwert k(AP) und der vorgegebene Sollwert K des gewünschten Arbeitspunktes übereinstimmen. Sollte sich hingegen der Istwert k(AP) wegen mangelnder Auflösung und Quantisierungsproblemen nicht genau einstellen, so führt die Unterschreitung des Istwerts k(AP) unter den Sollwert K im nächsten Schritt zu einer Erhöhung des Pulsstroms, im übernächsten Schritt wieder zu einer Verringerung des Pulsstroms usw.. Eine zweite, nicht dargestellte Auswertelogik untersucht daher den Pulsstrom, um im Fall eines alternierenden Pulsstroms die Arbeitspunktsuche ebenfalls zu beenden.

Da die alterungsbedingte Drift der Laserdiode gegenüber der temperaturbedingten relativ langsam vonstatten geht, braucht der Regelvorgang zur Suche der Lage des Arbeitspunktes nur in größeren Zeitabständen, z.B. einmal pro Tag im Dauerbetrieb, ausgelöst werden. Zwingend muß dieser Regelvorgang bei jedem Einschalten der Regelschaltung oder bei jeder Änderung der vorgegebenen Leistung ausgelöst werden.

Wie genau der ermittelte Istwert k(AP) des eingestellten Arbeitspunktes mit dem exakt berechenbaren Faktor K des eingestellten Arbeitspunktes tatsächlich übereinstimmt, hängt in erster Linie davon ab, wie groß das Verhältnis vom Vorstromschritt zum Pulsstromschritt gewählt wird. Aber auch selbst sehr große Stromschritte, wie in Fig. 3, ändern nichts an der Durchführbarkeit des Verfahrens. Der aus dem Istwert k(AP) abgeleitete Istwert S(AP) ist dann zwar nicht der exakte Wert des Verhältnisses der Steigung am linearen Teil der Kennlinie zu der Steigung am eingestellten Arbeitspunkt, vielmehr entspricht er einem Wert, der zwischen den exakten Werten der Faktoren S(AP) des vorangegangenen AP(a) und des eingestellten Arbeitspunktes AP(c) liegt.

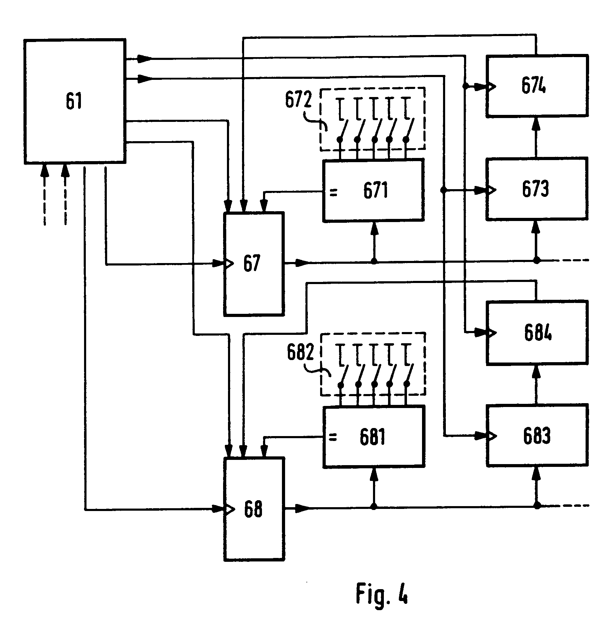

In Fig. 4 ist eine vorteilhafte Ausführungsform der Steuerschaltung 6 dargestellt. An die Ausgänge der Zähler 67, 68 sind ein zweiter und ein dritter Vergleicherbaustein 671, 682 angeschlossen. Der zweite Eingang dieser Vergleicherbausteine ist mit zwei Schalterreihen 672, 682 verbunden, mittels welchen binäre Werte vorgegeben werden. Der Ausgang eines jeden dieser Vergleicherbausteine 671, 681 ist mit einen Inhibit-Eingang des jeweiligen Zählers 67, 68 verbunden. Eine zweite und eine dritte Registerzelle 673, 683 ist sowohl mit den Ausgängen des jeweiligen Zählers 67, 68 als auch über Logikbausteine 674, 684 mit den Vorbesetzungseingängen der Zähler 67, 68 verbunden. Durch ein entsprechendes Steuersignal der Ablaufsteuerung 61 speichern diese Register den Zählerstand der zugehörigen Zähler. Ein zweites Steuersignal übergibt die mittels der Logikbausteine 674, 684 veränderten Werte den Registern 673, 683 an die Zähler 67, 68.

Bei dieser Ausführungsform kann zum einen eine schnelle Einregelung des Arbeitspunktes bzw. ein wirksamer Standby-Betrieb des Lasers erreicht werden. Die erste Inbetriebnahme erfolgt wie bei dem zuvor beschriebenen Ausführungsbeispiel. Vor einem Umschalten des Lasers in den Standby-Betrieb werden die augenblicklichen Werte der Zähler von Vorstrom und Pulsstrom in den Registern 673, 683 abgespeichert. Bei erneuter Inbetriebnahme des Lasers werden diese Werte bzw. die mittels der Logikbausteine 674, 684 veränderten Werte durch ein Signal der Ablaufsteuerung als Startwerte von dem Vorstromzähler 67 und dem Pulsstromzähler 68 übernommen. Ein unnötiges Durchlaufen der Kennlinie weit unterhalb des Schwellgebietes kann so vermieden werden. Um hierbei eine kurzzeitige Überbelastung der Laserdiode zu verhindern, ist es sinnvoll, zur Vorbesetzung der Zähler nicht die in den Registern 673, 683 gespeicherten Werte zu nehmen. Vielmehr werden diese Werte mit einem Sicherheitsfaktor, der die Temperaturänderung des Lasers durch Abkühlung etc. berücksichtigt, korrigiert. Diese Aufgabe lösen die Logikbausteine z.B. dadurch, daß sie die Bits der gespeicherten Binärwerte in zwei nicht dargestellten Schieberegistern in entsprechender Richtung um je ein Bit verschieben und so die Werte zur Vorbesetzung der Zähler 67 und 68 auf jeweils die Hälfte der ursprünglichen Werte reduzieren. Werden Laserdioden verwendet, bei denen die temperaturbedingte Änderung der Kennliniensteilheit sehr gering ist, so ist es ausreichend nur den Vorstromwert zu korrigieren.

Eine Dauerüberbelastung der Laserdiode wird durch die nachfolgend beschriebene Anordnung vermieden. Mit den Schalterreihen 672, 682 werden Maximalwerte für den Vorstrom- bzw. Pulsstromzähler vorgegeben. Bei Überschreiten dieser Werte verhindern die Vergleicherbausteine 671 bzw. 681 mit ihrem Ausgangssingal ein Weiterzählen des Vorstromzählers 67 bzw. des Pulsstromzählers 68.

Eine weitere nicht dargestellte Ausführungsform der Steuerschaltung 6 kann die Zeit zur Bestimmung des Arbeitspunktes nach dem Wiedereinschalten im Stand-by-Betrieb ebenfalls verkürzen. Hierzu sendet die Ablaufsteuerung 61 zu Beginn der Einregelphase sechzehn Zählimpulse an den Vorstromzähler 67. Hierdurch entspricht die Vorstromerhöhung dem sechzehnfachen Betrag eines Vorstromschrittes im ersten Ausführungsbeispiel.

Die größeren Vorstromschritte bieten den Vorteil, daß die vorgegebene Leistung schneller erreicht wird. Die Anzahl der Impulse wird dann nach und nach halbiert, um schließlich wieder mit den kleinsten Vorstromschritten zu arbeiten, mit welchen dann die Arbeitspunktbestimmung durchgeführt wird.

Diese Anordnung kann auch mit dem Ausführungsbeispiel in Fig. 4 kombiniert werden, wodurch noch schnellere Zeiten zur Bestimmung des Arbeitspunktes erreicht werden können.

In einer weiteren, nicht dargestellten Ausführungsform einer weiteren Steuerschaltung kann die Funktion der Regelschaltung und der Laserdiode überwacht werden.

Bei ordnungsgemäßer Funktion der Regelschaltung muß jede Änderung des Pulsstroms zu einer Änderung des Vorstromzählers und somit auch des Vorstroms führen. Wurde jedoch der Pulsstrom verändert, ohne daß sich der Wert des Vorstromzählers ändert, so muß ein Defekt der Regelschaltung vorliegen. Weiterhin liegt ein Fehlverhalten der Regelschaltung vor, wenn nach einem Pulsstromschritt die Änderung des Vorstroms größer ist als die Pulsstromänderung. Diese beiden Fehlverhalten können durch die Überwachung des Wertebereiches von k erfaßt werden:

Bei ordnungsgemäßer Funktion der Regelschaltung bewegt sich der Wert von k(AP) nur in dem Bereich zwischen d und dem Wert eins.

Zur Überwachung des Wertebereichs des Istwerts k(AP) werden parallel zu dem ersten Vergleicherbaustein 62 ein vierter und ein fünfter Vergleicherbaustein angeordnet, wobei deren erste Eingänge mit dem Ausgang des Subtrahierers 65 verbunden sind. Den anderen Eingängen wird der binäre Wert zehn, welcher wegen der zehnfachen Auflösung des Istwerts k(AP) dem Wert eins entspricht, zugeführt. Dem fünften Vergleicherbaustein wird mittels einer Reihe von Schaltern ein fünfter binärer Wert vorgegeben. Der Ausgang des vierten Vergleicherbausteins, der ein Signal führt, wenn der an den ersten Eingängen anliegende Wert den an den zweiten Eingängen anliegenden Wert erreicht bzw. überschreitet, ist mit einer akkustischen bzw. einer optischen Warnsignaleinrichtung verbunden. Ebenfalls mit dieser Warnsignaleinrichtung verbunden ist der Ausgang des fünften Vergleicherbausteins, der ein Signal führt, wenn der durch die Schalterstellungen vorgegebene Wert von dem an den zweiten Eingängen anliegenden Wert unterschritten wird. Der vierte Vergleicherbaustein löst somit ein Warnsignal aus, wenn der Istwert k(AP) den Wert eins überschreitet. Für die Warnsignalauslösung bei einem Unterschreiten des Wertes d muß der Wert des Tastgrades d des verwendeten Modulationssignals mittels der am fünften Vergleicherbaustein angeschlossenen Schalter eingestellt werden.

Durch Aufleuchten z.B. einer Leuchtdiode oder durch Ertönen eines Summers weist die Warneinrichtung den Benutzer auf ein Fehlverhalten der Regelschaltung, das z.B. durch eine defekte Laserdiode hervorgerufen werden kann, hin.

**Patentansprüche**

1. Schaltungsanordnung zur Regelung einer Laserdiode(1) mit
    - einer Vorstromquelle (7) zur Vorgabe eines Arbeitspunktes mittels eines durch die Laserdiode (1) fließenden Vorstroms (I1),

- einer Pulsstromquelle (8) zur Modulation der Laserdiode (1) mittels eines durch die Laserdiode (1) fließenden Pulsstroms (I2),
- einer mit der Laserdiode (1) gekoppelten Fotodiode (2) zur Messung der optischen Ausgangsleistung der Laserdiode (1) und
- einer Regelschaltung (6) zur Regelung der optischen Ausgangsleistung der Laserdiode (1)

dadurch gekennzeichnet,
daß zur Leistungsregelung der Laserdiode (1) die Regelschaltung (6) den Vorstrom (I1) nachregelt und daß zur Bestimmung des Arbeitspunktes der Laserdiode (1) aus dem augenblicklichen Kennlinienverlauf die Regelschaltung (6) den Pulstroms (I2) um einen bestimmten Betrag (I22) solange ändert, bis der Quotient (k) aus der sich auf die jeweilige Pulsstromänderung (I22) einstellenden Änderung (I11) des Vorstroms (I1) und der jeweils vorgenommen Pulsstromänderung (I22) mit einem vorgegebenen Sollwert (K) übereinstimmt, wobei der Arbeitspunkt an einen Punkt der Kennlinie gelegt wird, an dem die Steilheit niedriger als die Steilheit im linearen Bereich der Kennlinie ist.

2. Schaltungsanordnung zur Regelung einer Laserdiode nach Anspruch 1,
dadurch gekennzeichnet,
daß ein Komparator (4), dem ein zur Leistung der Laserdiode (1) proportionaler Wert zugeführt ist, und eine Steuerlogik (6) mit einem ersten Register (64), vorgesehen sind, wobei das erste Register (64) mit den Ausgängen eines die Vorstromquelle (7) steuernden Vorstromzählers (67) und Eingängen eines Subtrahierers (65) verbunden ist, und wobei weitere Eingänge des Subtrahierers (65) mit den Ausgängen des Vorstromzählers (67), der Ausgang des Subtrahierers (65) mit Eingängen eines ersten Vergleicherbausteins (62), weitere Eingänge des Vergleicherbausteins (62) mit einer Reihe von ersten Schaltern (621...625), dem ersten Register (64) und der erste Vergleicherbaustein (62) ausgangsseitig mit einer Ablaufsteuerung (61) und diese mit dem Vorstromzähler (67) einem die Pulsstromquelle (8) steuernden Pulsstromzähler (68) verbunden sind.

3. Schaltungsanordnung zur Regelung einer Laserdiode nach einem der vorangegangenen Ansprüche,
dadurch gekennzeichnet,
daß mindestens ein zweites Register (673) vorgesehen ist, das am Ausgang eines der beiden Zähler (67 bzw. 68) angeschlossen ist und mindestens ein zweiter Vergleicherbaustein (671) vorgesehen ist, dessen erster Eingang mit dem Ausgang des zweiten Registers (673) und dessen zweiter Eingang mit dem Ausgang des betreffenden Zählers (67 bzw. 68) verbunden ist und der Signalausgang des zweiten Vergleicherbausteins (671) mit dem Inhibit-Eingang des betreffenden Zählers (67 bzw. 68) verbunden ist.

4. Schaltungsanordnung zur Regelung einer Laserdiode nach einem der vorangegangenen Ansprüche,
dadurch gekennzeichnet,
daß wenigstens ein vierter Vergleicherbaustein vorgesehen ist, dessen erster Eingang mit den Ausgängen des Subtrahierers (65) verbunden ist und dessen Ausgang mit einer Warnsignaleinrichtung verbunden ist.

5. Schaltungsanordnung zur Regelung einer Laserdiode nach einem der vorangegangenen Ansprüche,
dadurch gekennzeichnet,
daß an mindestens einem der Ausgänge der Zähler (67) ein drittes Register (673), an den Ausgängen dieses dritten Registers (673) eine Logikbaugruppe (674, 684) angeschlossen ist, un daß die Ausgänge dieser Logikbaugruppe (674) mit den Pre-Set-Eingängen des besagten Zählers (67) verbunden ist.

6. Verfahren zur Regelung von Laserdioden, bei dem ein vorgebbarer Arbeitspunkt unmittelbar aus dem augenblicklichen Kennlinienverlauf bestimmt wird, wobei durch Auswertung der Kennliniensteilheiten der Arbeitspunkt mittels eines Vorstroms an einen Punkt der Kennlinie gelegt wird, an dem die Steilheit niedriger als die Steilheit im linearen Teil der Kennlinie ist, indem die optische Ausgangsleistung der Laserdiode mittels des Vorstroms geregelt wird, die Laserdiode mit einem Wechselstrom, dessen Mittelwert konstant ist, moduliert wird und die Amplitude dieses Wechselstroms so lange geändert wird, bis der Quotient aus der Differenz der beiden letzten Amplitudenwerte des Wechselstroms und der Differenz der beide Werte des Vorstroms vor und nach der auf die Amplitudenänderung des Wechselstroms erfolgenden Regelung der Ausgangsleistung einen bestimmten Wert einnimmt.

7. Verfahren zur Regelung einer Laserdiode nach Anspruch 6,
dadurch gekennzeichnet,
daß es sich bei dem Wechselstrom um einen binären Pulsstrom mit konstantem Tastverhältnis handelt.

8. Verfahren zur Regelung einer Laserdiode nach einem der obigen Ansprüche, dadurch gekennzeichnet, daß die Bestimmung des Arbeitspunktes während des Betriebs der Laserdiode in Abständen wiederholt wird.

9. Verfahren zur Regelung einer Laserdiode nach einem der obigen Ansprüche, dadurch gekennzeichnet, daß die vorgenommenen Änderungen der Amplitudenwerte allmählich bis auf einen Minimalwert verringert werden.

10. Verfahren zur Regelung einer Laserdiode nach einem der obigen Ansprüche, dadurch gekennzeichnet, daß die Parameter der Regelschaltung gespeichert werden und bei Inbetriebnahme der Laserdiode als Startwerte vorgegeben werden.

11. Verfahren zur Regelung einer Laserdiode nach einem der obigen Ansprüche, dadurch gekennzeichnet, daß die Werte von Vorstrom und Pulsstrom mit vorgegebenen Werten verglichen werden und daß ein Überschreiten der vorgegebenen Werte verhindert wird.

12. Verfahren zur Regelung einer Laserdiode nach einem der obigen Ansprüche, dadurch gekennzeichnet, daß die augenblicklichen Werte von Vorstrom und Pulsstrom mit vorgegebenen Maximalwerten verglichen werden und bei andauerndem Überschreiten eines dieser Maximalwerte ein Signal abgegeben wird, welches eine weitere Erhöhung des betreffenden Stromwerts verhindert.

13. Verfahren zur Regelung einer Laserdiode nach einem der obigen Ansprüche, dadurch gekennzeichnet, daß nach jeder Änderung des Pulsstroms die darauffolgende Änderung des Vorstroms überwacht wird, und daß bei Ausbleiben der Änderung des Vorstroms oder einer Änderung des Vorstroms, die größer ist als die vorherige Pulsstromänderung, ein Warnsignal abgegeben wird.

## Claims

1. Circuit arrangement for adjusting a laser diode (1), comprising
   - a bias current source (7) for predetermining an operating point by means of a bias current (I1) flowing through the laser diode (1),
   - a modulation current source (8) for modulating the laser diode (1) by means of a modulation current (I2) flowing through the laser diode,
   - a photodiode (2) coupled to the laser diode (1) for measuring the optical power output of the laser diode (1) and
   - an adjusting circuit (6) for adjusting the optical output power of the laser diode (1), characterized in that the adjusting circuit (6) readjusts the bias current (I1) to adjust the power of the laser diode (1) and in that, to determine the operating point of the laser diode (1) from the instantaneous characteristic curve, the adjusting circuit (6) changes the modulation current (I2) by a specific amount (I22) for such a length of time that the quotient (k) of the change (I11) of the bias current (11) adapting to the modulation current change (I22) and the effected modulation current change (I22) corresponds to a predetermined nominal value (K), while the operating point is situated at a point on the characteristic curve at which the slope is smaller than the slope in the linear area of the characteristic curve.

2. Circuit arrangement for adjusting a laser diode as claimed in Claim 1, characterized in that the arrangement comprises a comparator (4) which is supplied with a value proportional to the power of the laser diode (1), and a control logic (6) having a first register (64), the first register, the first register (64) being connected to the outputs of a bias current counter (67) controlling the bias current source (7) and inputs of a subtracter (65), and further inputs of the subtracter (65) being connected to the outputs of the bias current counter (67), the output of the subtracter (65) being connected to inputs of a first comparator module (62), further inputs of the comparator module (62) being connected to a series of first switches (621 ...625), to the first register (64) and the output of the first comparator module (62) being connected to a run-off control (61) and the latter to the bias current counter (67) and a modulation current counter (68) controlling the modulation current counter (8).

3. Circuit arrangement for adjusting a laser diode as claimed in one of the preceding Claims, characterized in that at least a second register (673) is included, which is connected to the output of one of the two counters (67,68, respectively) and at least a second comparator module (671) is included, whose first input is connected to the output of the second register (673) and whose second input is connected to the output of the counter concerned (67,68, respectively) and the signal output of the second comparator module (671) is connected to the inhibit input of the counter concerned (67,68, respectively).

4. Circuit arrangement for adjusting a laser diode as claimed in one of the preceding Claims, characterized in that at least a fourth comparator module is included, whose first input is connected to the outputs of the subtracter (65) and whose output is connected to a warning device.

5. Circuit arrangement for adjusting a laser diode as claimed in one of the preceding Claims, characterized in that to at least one of the outputs of the counter (67) is connected a third register (673) to whose outputs a logic assembler (674, 684) is connected, and in that the outputs of this logic assembler (674) are connected to the preset inputs of aforesaid counter (67).

6. Method for adjusting laser diodes in which a predeterminable operating point is determined directly from the instantaneous shape of the characteristic curve, while an evaluation of the slopes of the characteristic curve provides that the operating point is put by means of a bias current at that point on the characteristic curve where the slope is smaller than the slope in the linear part of the characteristic curve, so that the optical output power of the laser diode is adjusted by means of the bias current, the laser diode is modulated with a constant mean-value alternating current and the amplitude of this alternating current is changed for such a length of time that the quotient of the difference between the two most recent amplitude values of the alternating current and the difference between the two values of the bias current before and after the output power adjustment following the amplitude change of the alternating current adopts a specific value.

7. Method for adjusting a laser diode as claimed in Claim 6, characterized in that the alternating current is understood to mean a binary modulation current having a constant duty cycle.

8. Method for adjusting a laser diode as claimed in one of the preceding Claims, characterized in that the operating point is determined at regular intervals while the laser diode is in operation.

9. Method for adjusting a laser diode as claimed in one of the preceding Claims, characterized in that the intended changes of the amplitude values are gradually reduced to a minimum value.

10. Method for adjusting a laser diode as claimed in one of the preceding Claims, characterized in that the parameters of the adjusting circuit are stored and given as initial values when the laser diode is put into operation.

11. Method for adjusting a laser diode as claimed in one of the preceding Claims, characterized in that the values of bias current and modulation current are compared with predetermined values and in that a transgression of the predetermined values is avoided.

12. Method for adjusting a laser diode as claimed in one of the preceding Claims, characterized in that the instantaneous values of bias current and modulation current are compared with predetermined maximum values and when one of these maximum values is constantly exceeded, a signal is given preventing a further increase of the relevant current value.

13. Method for adjusting a laser diode as claimed in one of the preceding Claims, characterized in that after each change of the modulation current the subsequent change of the bias current is monitored, and in that a warning signal is given when the change of the bias current or a change of the bias current that exceeds the previous change of the modulation current, fails to occur.

**Revendications**

1. Montage de circuit pour la régulation d'une diode laser (1) comprenant:
   - une source de courant de polarisation (7) pour prédéfinir un point de fonctionnement à l'aide d'un courant de polarisation (I1) s'écoulant à travers la diode laser (1),
   - une source de courant pulsé (8) pour moduler la diode laser (1) à l'aide d'un courant pulsé (I2) s'écoulant à travers la diode laser (1),
   - une photodiode (2) couplée à la diode laser (1) pour mesurer la puissance optique de sortie de la diode laser (1), et
   - un circuit de régulation (6) pour régler la puissance optique de sortie de la diode laser (l),caractérisé en ce que pour effectuer la régulation de puissance de la diode laser (1), le circuit de régulation (6) réajuste le courant de polarisation (I1), et que, pour déterminer le point de fonctionnement de la diode laser (1) à partir du tracé instantané de la caractéristique, le circuit de régulation (6) modifie le courant pulsé (I2) d'une quantité déterminée (I22) jusqu'à ce que le quotient (k) de la variation (I11) du courant de polarisation (I1) qui s'ajuste sur la variation respective (I22) du courant pulsé (I2) et de la variation (I22) du courant pulsé respectivement effectuée coïncide avec une valeur de consigne (K) prédéfinie, le point de fonctionnement étant placé en un point de la caractéristique où la pente est moindre que celle du domaine linéaire de la caractéristique.

2. Montage de circuit de régulation d'une diode laser selon la revendication 1, caractérisé en ce qu'il comprend un comparateur (4) auquel est acheminée une valeur proportionnelle à la puissance de la diode laser (1), et un circuit logique de commande (6) comportant un premier registre (64), le premier registre (64) étant connecté aux sorties d'un compteur de courant de polarisation (67) commandant la source de courant de polarisation (7) et aux entrées d'un soustracteur (65), d'autres entrées du soustracteur (65) étant connectées aux sorties du compteur de courant de polarisation (67), la sortie du soustracteur (65) étant connectée à des entrées d'un premier composant comparateur (62), d'autres entrées du composant comparateur (62) étant connectées à une série de premiers commutateurs (621 ... 625), et au premier registre (64), et le premier composant comparateur (62) étant connecté côté sortie à une commande séquentielle (61) et celle-ci au compteur de courant de polarisation (67) et à un compteur de courant pulsé (68) commandant la source de courant pulsé (8).

3. Montage de circuit pour la régulation d'une diode laser selon l'une quelconque des revendications précédentes, caractérisé en ce qu'il comporte au moins un deuxième registre (673) qui est connecté à la sortie d'un des deux compteurs (67, 68) et au moins un deuxième composant comparateur (671) dont la première entrée est connectée à la sortie du deuxième registre (673) et dont la deuxième entrée est connectée à la sortie du compteur concerné (67 ou 68), le signal de sortie du deuxième composant comparateur (671) étant appliqué à l'entrée d'inhibition du compteur concerné (67, 68).

4. Montage de circuit pour la régulation d'une diode laser selon l'une quelconque des revendications précédentes, caractérisé en ce qu'il comporte au moins un quatrième composant comparateur, dont la première entrée est connectée aux sorties du soustracteur (65) et dont la sortie est connectée à un dispositif d'avertissement.

5. Montage de circuit pour la régulation d'une diode laser selon l'une quelconque des revendications précédentes, caractérisé en ce qu'un troisième registre (673) est connecté à au moins une des sorties du compteur (67) et aux sorties de ce troisième registre (673) est connecté un groupe logique (674, 684) et que la sortie de ce groupe logique (674) est connectée aux entrées de préréglage dudit compteur (67).

6. Procédé de régulation de diodes lasers dans lequel on détermine un point de fonctionnement prédéfinissable directement à partir du tracé instantané de la caractéristique, en plaçant par évaluation des pentes des caractéristiques, le point de fonctionnement à l'aide d'un courant de polarisation sur un point de la caractéristique où la pente est moindre que celle de la partie linéaire de la caractéristique, en réglant la puissance optique de sortie de la diode laser à l'aide du courant de polarisation, en modulant la diode laser à l'aide d'un courant alternatif, dont la valeur moyenne est constante, et en modifiant l'amplitude de ce courant alternatif jusqu'à ce que le quotient de la différence des deux dernières valeurs de l'amplitude du courant alternatif et de la différence des deux valeurs du courant de polarisation, avant et après la régulation de la puissance de sortie qui résulte de la variation d'amplitude du courant alternatif, adopte une valeur déterminée.

7. Procédé de régulation d'une diode laser selon la revendication 6, caractérisé en ce que le courant alternatif est un courant pulsé binaire avec un taux d'utilisation constant.

8. Procédé de régulation d'une diode laser selon l'une quelconque des revendications précédentes, caractérisé en ce que la détermination du point de fonctionnement est répétée à intervalles au cours de l'exploitation de la diode laser.

9. Procédé de régulation d'une diode laser selon l'une quelconque des revendications précédentes, caractérisé en ce que les variations effectuées des valeurs d'amplitude sont graduellement réduites à une valeur minimum.

10. Procédé de régulation d'une diode laser selon l'une quelconque des revendications précédentes, caractérisé en ce que les paramètres du circuit de régulation sont mémorisés et, lors de la mise en exploitation de la diode laser, ils sont prédéterminés comme valeurs de démarrage.

11. Procédé de régulation d'une diode laser selon l'une quelconque des revendications précédentes, caractérisé en ce que les valeurs du courant de polarisation et du courant pulsé sont comparées aux valeurs prédéterminées et en ce que l'on empêche un dépassement par excès des valeurs prédéfinies.

12. Procédé de régulation d'une diode laser selon quelconque des revendications précédentes, caractérisé en ce que les valeurs instantanées du courant de polarisation et du courant pulsé sont comparées à des valeurs maxima prédéterminées et, lorsque l'on dépasse de manière persistante une de ces valeurs maxima, un signal qui empêche une autre augmentation de la valeur de courant concernée est délivré.

13. Procédé de régulation d'une diode laser selon l'une quelconque des revendications précédentes, caractérisé en ce que après chaque modification du courant pulsé, la variation du courant de polarisation qui s'ensuit est contrôlée et en ce que, lorsque la variation du courant de polarisation reste absente ou lors d'une variation du courant de polarisation qui est supérieure à la variation du courant pulsé précédente, un signal d'avertissement est délivré.

Fig. 1

Fig. 2

Fig. 3

Fig. 4